# EUROPÄISCHE PATENTSCHRIFT

(11) **EP 1 952 169 B1**
(45) Veröffentlichungstag und Bekanntmachung des Hinweises auf die Patenterteilung: **12.08.2015**
(21) Anmeldenummer: 06818060.3
(22) Anmeldetag: 08.11.2006
(51) Int. Cl.: G01R 31/36

(54) **VERFAHREN ZUM ERMITTLEN DES BETRIEBSZUSTANDS EINES AKKUMULATORS**
METHOD FOR DETERMINING STORAGE BATTERY OPERATING CONDITIONS
PROCEDE POUR DETERMINER L'ETAT DE FONCTIONNEMENT D'UN ACCUMULATEUR

(30) Priorität: 25.11.2005 DE 102005056555; 22.12.2005 DE 102005062148
(43) Veröffentlichungstag der Anmeldung: 06.08.2008
(73) Patentinhaber: Audi AG, 85045 Ingolstadt (DE)
(72) Erfinder: NAUMANN, Rolf, 96247 Michelau (DE)
(74) Vertreter: Patent- und Rechtsanwälte Ullrich & Naumann
(86) Internationale Anmeldenummer: PCT/DE2006/001958
(87) Internationale Veröffentlichungsnummer: WO 2007/059725

(56) Entgegenhaltungen:
- EP-A- 1 231 476
- EP-A- 1 462 815
- US-A- 5 349 540
- US-A- 5 936 383

## Beschreibung

Die Erfindung betrifft ein Verfahren zum Ermitteln des Betriebszustands eines Energiespeichers für elektrische Energie, wobei der Energiespeicher eine Batterie oder einen Akkumulator umfasst, wobei die Klemmenspannung des Energiespeichers, der in den Anschlussleitungen des Energiespeichers fließende Strom und die Temperatur des Energiespeichers oder die Temperatur in der unmittelbaren Umgebung des Energiespeichers erfasst werden, und wobei der Betriebszustand im Wesentlichen durch einzelne Kenngrößen definiert ist.

Moderne Fahrzeuge sind mit einer Vielzahl von elektrischen Geräten ausgestattet, die in der Summe in größerem Umfang elektrischer Energie aus dem Bordnetz des Fahrzeugs beziehen. Zu den seit vielen Jahren bekannten elektrischen Verbrauchern wie Beleuchtungsanlage, Anlasser des Motors oder Stereoanlage sind vielfach weitere elektrische Verbraucher wie elektrische Fensterheber, Klimaanlage, Alarmanlage, verschiedenste Steuergeräte oder Motormanagementsystem getreten. Gleichzeitig mit dem gestiegenen Verbrauch wird bedingt durch den stark beschränkten Bauraum die verfügbare Energie vermindert. Zur Gewährleistung der wesentlichen Funktionalitäten wie beispielsweise das Anlassen des Fahrzeugs und weitere grundlegende Betriebsphasen ist es daher notwendig, den Betriebszustand des Fahrzeugakkumulators relativ genau zu kennen.

Das Ermitteln des Betriebszustands des Akkumulators oder der Batterie sollte dabei selbständig und ohne notwendige Einflussnahme des Fahrzeugnutzers erfolgen. Idealerweise wird der Fahrzeugnutzer lediglich über das Eintreten eines kritischen Betriebszustandes informiert während bei normalen Betriebszuständen Informationen über den Betriebszustand lediglich auf ausdrückliche Anfrage des Nutzers erfolgen. Aus der Praxis sind bereits einige Verfahren bekannt, mit denen ein Ermitteln des Betriebszustands möglich ist. Bei einem Verfahren wird die Ruhespannung der Batterie oder des Akkumulators zusammen mit der Umgebungstemperatur gemessen. Da die Ruhespannung von dem Ladezustand der' Batterie oder des Akkumulators abhängt, kann über die Ruhespannung auf den Ladezustand der Batterie oder des Akkumulators geschlossen werden. Dazu ist eine Kennlinie, die die eingesetzte Batterie oder Akkumulator beschreibt, hinterlegt und wird zur Zuordnung der gemessenen Ruhespannung zu dem Ladezustand genutzt. Neben der Tatsache, dass hier typenspezifische Informationen vorliegen müssen, erweist sich das mangelnde Erkennen von Alterungsprozessen bei diesem Verfahren als nachteilig. Zusätzlich ist die Ruhespannung von vielen weiteren Einflussgrößen abhängig.

Andere aus der Praxis bekannten Verfahren können beim laufenden Betrieb des Energiespeichers eingesetzt werden. Hierbei wird die Impedanz des Energiespeichers gemessen und ebenfalls über eine hinterlegte Kennlinie oder mathematisches oder physikalisches Modell bestimmt. Auch bei diesem Verfahren muss jedoch ein relativ detailliertes Wissen über den eingesetzten Energiespeicher vorliegen, um den Betriebszustand mit einem vertretbaren Fehler zu ermitteln.

Die Druckschrift US 5,349,540 A offenbart ein Verfahren zur Bestimmung des Zustands physikalischer Eigenschaften wiederaufladbarer Batterien unter Verwendung eines Beobachtersystems. Das Beobachtersystem enthält ein Batteriemodell, dass das Verhalten der Batterie modelliert. In das Batteriemodell werden als Eingangsgrössen Messwerte des Batteriestroms, der Batterietemperatur und der Umgebungstemperatur eingegeben. Unter Verwendung dieser Messwerte schätzt das Batteriemodell die Klemmenspannung, die entnehmbare Ladungsmenge und den differenziellen Ladewirkungsgrad ab. Über einen Vergleich der gemessenen Klemmenspannung mit der geschätzten Klemmenspannung werden Modellparameter angepasst.

Der vorliegenden Erfindung liegt daher die Aufgabe zugrunde, ein Verfahren der eingangs genannten Art derart auszugestalten und weiterzubilden, dass ein Ermitteln des Betriebszustands des Energiespeichers auf einfache Art ermöglicht wird, wobei aufwendige Einstellvorgänge vermieden werden sollen.

Erfindungsgemäß wird die voranstehende Aufgabe durch die Merkmale des Patentanspruchs 1 gelöst. Danach ist das in Rede stehende Verfahren derart ausgestaltet, dass die im Wesentlichen unbekannten Kenngrößen des Energiespeichers geschätzt werden, dass für die geschätzten Kenngrößen zunächst Startwerte gewählt werden, dass basierend auf die Startwerte und die erfassten Messgrößen mittels eines mathematischen Modells eine erwartete Messgröße bestimmt und mit der erfassten Messgröße verglichen wird und dass bei Abweichen der erwarteten Messgröße von der erfassten Messgröße einer oder mehrere der Startwerte angepasst werden.

In erfindungsgemäßer Weise ist zunächst erkannt worden, dass auf aufwendige Einstellvorgänge, bei denen die wesentlichen Kenngrößen des Energiespeichers in das System zum Ermitteln des Betriebszustandes eingegeben werden, verzichtet werden kann. Vielmehr ist es möglich, ein Verfahren anzugeben, das ohne die Eingabe von typenspezifischen Kenngrößen auskommt. Dazu werden die im Wesentlichen unbekannten Kenngrößen des Energiespeichers geschätzt. Ausgehend von relativ beliebig gewählten Startwerten für die Kenngrößen wird erfindungsgemäß mittels eines mathematischen Modells unter Verwendung von Startwerten und erfassten Messgrößen eine erwartete Messgröße bestimmt. Hierbei lassen sich vorteilhafterweise mathematische Modelle einsetzen, die lediglich von der eingesetzten Art von Energiespeicher abhängen. Die derart bestimmte erwartete Messgröße wird mit der erfassten Messgröße verglichen. Bei Abweichungen zwischen der erwarteten Messgröße und der erfassten Messgröße werden einer oder mehrere der Startwerte angepasst. Erfindungsgemäß ist es auch möglich, mehrere erwartete Messgrößen mittels eines oder mehrerer mathematischen Modelle zu bestimmen und mit den korrespondierenden Messgrößen oder unmittelbar daraus berechenbaren Größen zu vergleichen.

Bevorzugterweise umfasst der Energiespeicher dabei eine Nass-Batterie oder einen Nass-Akkumulator. Das erfindungsgemäße Verfahren beschränkt sich jedoch nicht auf diese Energiespeicher. Vielmehr kann das erfindungsgemäße Verfahren im Zusammenhang mit den verschiedensten Batterien und Akkumulatoren eingesetzt werden. So lässt sich beispielsweise der Betriebszustand von Gel-Akkumulatoren oder konventionellen Alkalibatterien ebenso bestimmen. Hierbei ist es lediglich notwendig, das den Energiespeicher beschreibende Modell entsprechend anzupassen.

Bevorzugterweise werden als Kenngrößen lediglich der Ladezustand und/oder die Kapazität des Energiespeichers berücksichtigt. Damit lässt sich der Betriebszustand des Energiespeichers bereits relativ genau definieren. Durch Hinzunahme weiterer Kenngrößen könnte der Betriebszustand jedoch noch genauer abgegrenzt werden.

Hinsichtlich einer möglichst geringen Abweichung zwischen den tatsächlichen Kenngrößen und den geschätzten Kenngrößen wird das Bestimmen der erwarteten Messgröße, der Vergleich der erwarteten Messgröße mit der gemessenen Messgröße und das Anpassen der Startwerte bzw. der geschätzten Kenngrößen iteriert. Idealerweise nähern sich mit jeder Iteration die geschätzten Kenngrößen den tatsächlich vorliegenden Kenngrößen. Dazu sollte mit jedem Iterationsschritt die bei dem vorhergehenden Iterationsschritt bestimmten Kenngrößen als Eingangswerte genutzt werden. Dabei könnte zusätzlich überprüft werden, ob sich die Differenz zwischen der erwarteten Messgröße und der gemessenen Messgröße mit einem Iterationsschritt reduziert. Bei größer werdender Differenz könnte die Anpassungsrichtung geändert werden, d.h. statt einer Erhöhung einer Kenngröße sollte eine Absenkung erfolgen bzw. umgekehrt. Voraussetzung hierzu ist, dass ein im Wesentlichen monotoner Funktionsverlauf des mathematischen Modells gegeben ist. Vorzugsweise wird die Iteration solange durchgeführt, bis sich die Abweichung zwischen der erwarteten Messgröße und der erfassten Messgröße in einem vorgegebenen Bereich befindet. Durch die sukzessive Annäherung der Kennwerte kann insbesondere ein Schwingen der bestimmten Werte effektiv verhindert werden.

Verschiedene Kenngrößen des Energiespeichers sind Schwankungen unterworfen. So ändert sich naturgemäß mit der Entnahme von Energie aus dem Energiespeicher oder bei einem Ladevorgang der Ladezustand. Daher muss dieser Wert in vergleichsweise kurzen Zeitabständen aktualisiert werden. Andere Kenngrößen wie die Kapazität des Energiespeichers sind lediglich langsamen Schwankungen unterworfen. So sinkt in Folge der Alterung die Kapazität des Energiespeichers im Verlauf von Monaten oder gar Jahren. Insbesondere bei Nassbatterien kann Säureschichtung die Kapazität zusätzlich beeinflussen. Säureschichtung beschreibt den Effekt, dass sich beim Laden des Energiespeichers die Säure, beispielsweise die Schwefelsäure eines Bleiakkumulators, aufgrund des gegenüber dem Verdünnungsmittel (im Allgemeinen Wasser) höheren spezifischen Gewichts im unteren Bereich des Akkumulators ansammelt.

Damit die aktualisierten Kenngrößen möglichst genau bestimmt werden können, ist eine möglichst zeitnahe Erfassung der Messgrößen sinnvoll. Dazu kann nach einer festgelegten Anzahl von Berechnungsschritten eine neue Erfassung ausgelöst werden. Ebenso wäre es denkbar, nach einer festgelegten Zeitspanne neue Messgrößen zu erfassen. Allerdings können auch andere Ereignisse oder Kriterien eine Erfassung triggern. So wäre es denkbar, Sprünge in der Strombelastung zu detektieren und bei Auftreten eines entsprechenden Sprungs über einen vorgegebenen Bereich hinaus eine Erfassung der notwendigen Messgrößen einzuleiten.

Hinsichtlich einer möglichst korrekten Bestimmung des Ladezustands des Energiespeichers wäre eine Messung der aus dem Energiespeicher entnommenen Ladungsmenge zu erwägen. Vorzugsweise könnte die entnommene Ladungsmenge durch einen Amperestundenzähler bestimmt werden. Die Messung der entnommenen Ladungsmenge könnte dabei fortwährend erfolgen. Darüber hinaus könnte bei Akkumulatoren die in den Energiespeicher zurück gespeiste Energiemenge gemessen und erfasst werden.

Die auf diese Weise bestimmte aus dem Energiespeicher entnommene bzw. eingespeiste Ladungsmenge könnte dann zu einer Überprüfung und gegebenenfalls zu einer Korrektur des Ladezustands des Energiespeichers genutzt werden. Dazu wird der Ladezustand des Energiespeichers mehrfach geschätzt. Jede Schätzung sollte dabei in einem zeitlichen Abstand erfolgen. Die Differenz der geschätzten Werte des Ladezustands zu zwei aufeinander folgenden Zeitpunkten könnte dann mit der in demselben Zeitraum aus dem Energiespeicher entnommenen gemessenen Ladungsmenge verglichen werden. Weichen die beiden Differenzen über ein vorgebbares Ausmaß hinaus voneinander ab, so kann darauf geschlossen werden, dass mindestens eine Kenngröße nicht korrekt bestimmt wurde. Eine Korrektur der entsprechenden Kenngröße des Energiespeichers ist daher angebracht.

Bei der Bestimmung des Startwerts sind verschiedene Ansätze denkbar. So können typischerweise zu erwartende Werte gewählt werden. Bei jeder Vorrichtung, die einen Energiespeicher für elektrische Energie einsetzt, sind bestimmte Arten und Dimensionierungen von Energiespeicher gebräuchlich. Dies kann sich beispielsweise danach richten, mit welcher Art von Energiespeicher die Vorrichtung durch den Hersteller ausgeliefert wird. Derartige Werte bilden einen guten Ausgangspunkt für die Bestimmung der tatsächlichen Kenngrößen. Durch die wiederholte Iteration des Bestimmens der erwarteten Messgröße, des Vergleichs der erwarteten Messgrößen mit der gemessenen Messgröße und des Anpassens der geschätzten Kenngrößen nähern sich die geschätzten Kenngrößen vergleichsweise schnell den tatsächlichen Kenngrößen.

Alternativ oder zusätzlich könnte aus den erfassten Messgrößen als erste Näherung auf die vorliegenden Kenngrößen geschlossen werden. Diese Kenngrößen könnten wiederum durch ein mathematisches Modell berechnet oder aus einer Tabelle, die eine Zuordnung entsprechender Messgrößen zu den Kenngrößen des Energiespeichers enthält, ausgelesen werden. Durch die Iteration können relativ ungenaue Modelle genutzt werden. Die geschätzten Kenngrößen werden im Allgemeinen dennoch gegen die tatsächlichen Werte konvergieren.

Bei der Bestimmung aus erfassten Messgrößen könnten auch gezielt Zustandsänderungen herbeigeführt werden. Dabei könnte beispielsweise durch ein Lade- oder einen Entladepuls das Verhalten des Energiespeichers beobachtet und/oder analysiert werden. Die Startwerte lassen sich dann aus dem Verhalten des Energiespeichers unter Verwendung eines mathematischen Modells oder einer geeigneten Zuordnungsvorschrift bestimmt werden

Darüber hinaus könnten einzelnen Kenngrößen typischerweise zu erwartende Werte als Startwerte zugewiesen werden, während andere Startwerte durch die erfassten Messgrößen und/oder die bereits auf andere Weise bestimmten Startwerte beeinflusst werden. Letztere könnten wiederum durch ein mathematisches Modell berechnet oder aus einer Tabelle ausgelesen werden.

Als mathematische Modelle kommen die verschiedensten Beschreibungen des Verhaltens des Energiespeichers in einzelnen Betriebssituationen in Frage. So könnte beispielsweise ein mathematisches Modell genutzt werden, das das Entladeverhalten der jeweiligen Art von Energiespeicher beschreibt. Auf der anderen Seite könnte auch ein Lademodell, das das Ladeverhalten des Energiespeichers beschreibt, genutzt werden. Darüber hinaus sind Beschreibungen basierend auf Impedanzmodelle denkbar. Je nach Betriebssituation könnte auch zwischen einzelnen Modellen gewechselt werden. So könnte während eines Entladevorgangs ein Entlademodell für Berechnungen herangezogen werden, während bei Ladevorgängen auf ein Lademodell gewechselt wird. Darüber hinaus sind sämtliche Verfahren und Modelle einsetzbar, die das Verhalten des jeweiligen Energiespeichers hinlänglich genau beschreiben oder annähern.

Im Allgemeinen wird es sich bei dem mathematischen Modell um eine mathematische Funktion höherer Ordnung handeln, beispielsweise ein Polynom. Die einzelnen Koeffizienten der Funktion sind von dem in den Anschlussleitungen des Energiespeichers fließenden Strömen, der Temperatur und/oder weiteren Betriebsbedingungen und -größen abhängig.

Bei der Anwendung des erfindungsgemäßen Verfahrens könnten die mathematischen Modelle zu einer unmittelbaren Berechnung der jeweiligen Werte herangezogen werden. Dies setzt jedoch entsprechende Berechnungsressourcen voraus. Bei Anwendungen, bei denen entsprechende Leistungsfähigkeiten für die Berechnung nicht vorliegen, könnten eine Offline-Berechnung und ein anschließendes Ablegen der berechneten Werte in einer Tabelle sinnvoll sein.

Es gibt nun verschiedene Möglichkeiten, die Lehre der vorliegenden Erfindung in vorteilhafter Weise auszugestalten und weiterzubilden. Dazu ist einerseits auf die dem Patentanspruch 1 nachgeordneten Patentansprüche und andererseits auf die nachfolgende Erläuterung eines bevorzugten Ausführungsbeispiels der Erfindung anhand der Zeichnung zu verweisen. In Verbindung mit der Erläuterung des bevorzugten Ausführungsbeispiels der Erfindung anhand der Zeichnung werden auch im Allgemeinen bevorzugte Ausgestaltungen und Weiterbildungen der Lehre erläutert. In der Zeichnung zeigen
- Fig. 1: in einer schematischen Darstellung eine Vorrichtung zur Anwendung eines erfindungsgemäßen Verfahrens und
- Fig. 2: exemplarisch ein Ablaufdiagramm zur Durchführung des erfindungsgemäßen Verfahrens.

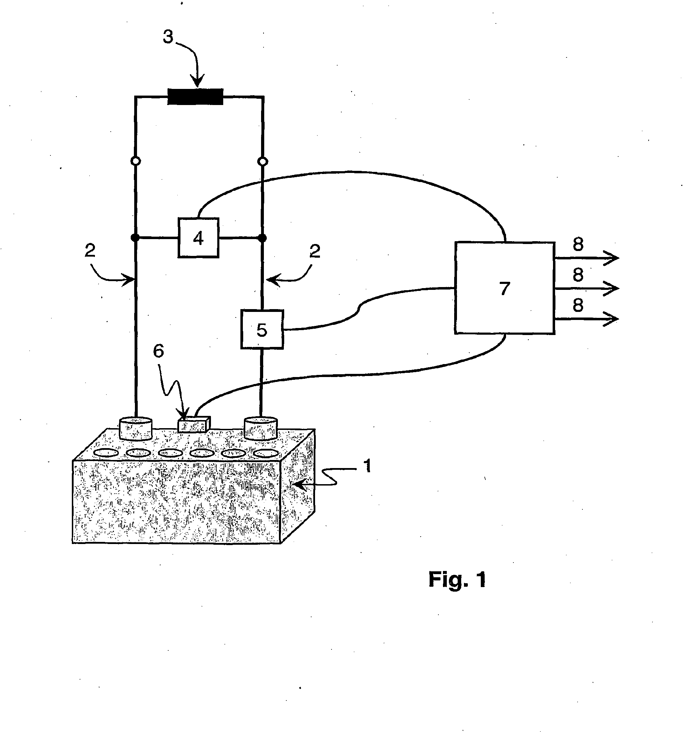

Fig. 1 zeigt schematisch eine Vorrichtung, die zur Anwendung eines erfindungsgemäßen Verfahrens geeignet ist. Eine derartige Vorrichtung könnte in einem Fahrzeug zum Einsatz kommen. Ein Bleiakkumulator 1 ist über Anschlussleitungen 2 mit einem oder mehreren Verbrauchern 3 verbunden. Dadurch fließt in den Zuleitungen 2 ein Strom, der mit einem Strommesser 4 erfasst wird. Parallel zu dem Verbraucher 3 ist ein Spannungsmesser 5 geschaltet, der die durch den Akkumulator 1 ausgegebene Spannung misst. Ein Temperaturmesser erfasst die Temperatur des Akkumulators bzw. die Temperatur im unmittelbaren Umfeld des Akkumulators. Im einfachsten Fall ist der Temperatursensor 6 an einer der Anschlussklemmen angebracht, mit denen die Zuleitungen 2 mit dem Akkumulator 1 verbunden werden. Die einzelnen Sensoren 4, 5 und 6 sind in geeigneter Weise mit einem Mikrorechner 7 verbunden, der zur Berechnung oder Bestimmung von verschiedenen Ausgangswerten 8 ausgebildet ist. Diese Ausgangswerte 8 könnten geschätzte Kenngrößen, Warnhinweise an den Nutzer, Informationen über das Alterungsverhalten des Energiespeichers 1 oder dergleichen umfassen. Der Mikrorechner 7 könnte durch einen gesonderten Mikroprozessor, einen digitalen Signalprozessor, einen FPGA, einen ASIC oder andere geeignete Vorrichtungen gebildet werden. Eine Integration der Funktionalitäten in einem der im Fahrzeug verfügbaren Steuergeräte ist ebenso denkbar.

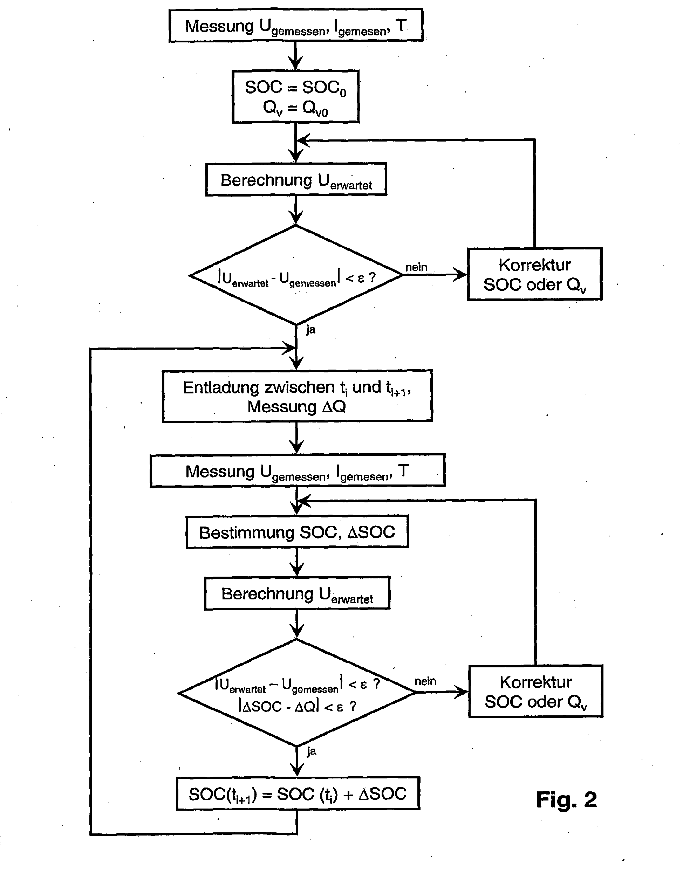

In Fig. 2 ist exemplarisch der Ablauf bei der Bestimmung der Betriebsparameter des Akkumulators 1 dargestellt. Nach Messung der Spannung U_{gemessen}, des Stroms I_{gemessen} und der Temperatur T werden in einem zweiten Schritt der Ladezustand SOC und die Kapazität Oᵥ des Akkumulators 1 auf Startwerte SOC₀ und Qᵥ₀ gesetzt. Dazu ist in dem Mikrorechner 7 ein Kapazitätswert des in dem Fahrzeug typischerweise eingesetzten Akkumulators abgelegt. Der Ladezustand SOC wird aus diesem Kapazitätswert Qᵥ₀ und der durch den Spannungsmesser 5 gemessenen Spannung U_{gemessen} bestimmt. Bei dessen Berechnung können größere Fehler in Kauf genommen werden, da durch spätere Iterationsschritte ungenaue Annahmen korrigiert werden.

In dem Mikrorechner 7 ist ferner ein mathematisches Modell gespeichert, das basierend auf den in den Anschlussleitungen 2 fließenden Strom I_{gemessen}, die Temperatur T, den aktuellen Ladezustand SOC und die Kapazität Qᵥ des Akkumulators eine erwartete Ausgangsspannung U_{erwartet} des Akkumulators 1 bestimmt. Dabei kommt ein allgemein für die verwendeten Art von Akkumulatoren - in diesem Fall ein Blei-Akkumulator - zum Einsatz. Dadurch ist die Bestimmung der Kapazität und des Ladezustands von dem Typ des verwendeten Akkumulators unabhängig. Insbesondere wird keine lediglich für einzelne Akkumulatoren gültige Kennlinie benötigt. Auf diese Weise wird vermieden, dass beim Wechsel des Typs des Akkumulators die Kennlinie neu in den Mikrorechner abgelegt werden muss. Es ist lediglich von Bedeutung, welche Art von Akkumulator, beispielsweise ein Bleiakkumulator oder ein Gelakkumulator, im Zusammenhang mit dem erfindungsgemäßen Verfahren eingesetzt wird.

In einem weiteren Schritt wird die durch das mathematische Modell bestimmte erwartete Spannung U_{erwartet} mit der tatsächlich gemessenen Spannung U_{gemessen} verglichen. Ergibt der Vergleich, dass sich die Differenz zwischen den beiden Spannungen unterhalb einer vorgebbaren Schwelle ε befindet, werden die Startwerte zunächst akzeptiert. Im Allgemeinen wird jedoch eine Abweichung zwischen den beiden Spannungswerten auftreten. In diesem Fall kann davon ausgegangen werden, dass eine der beiden oder sogar beide Startwerte unkorrekt sind. Eine entsprechende Korrektur einer der beiden Werte ist notwendig. In einer ersten Näherung könnte der Ladezustand SOC nach oben oder nach unten korrigiert werden. Im Anschluss erfolgt eine erneute Berechnung der erwarteten Ausgangsspannung des Akkumulators 1 durch das mathematische Modell. Erneut wird überprüft, ob die erwartete Spannung U_{erwartet} und die gemessene Spannung U_{gemessen} nahe genug beieinander liegen. Treten erneut größere Differenzen als die vorgegebene Schwelle ε auf, so muss erneut der Ladezustand oder die Kapazität der Batterie korrigiert werden. Vorteilhafterweise könnte hierbei berücksichtigt werden, ob die in dem vorangegangenen Iterationsschritt bestimmte Differenz zwischen der erwarteten und der gemessenen Spannung geringer geworden ist. Ist dies der Fall, so wurde sehr wahrscheinlich der Startwert in die richtige Richtung korrigiert. Andernfalls wäre eine Korrektur in die entgegengesetzte Richtung oder die Korrektur des anderen Parameters angebracht.

Im Allgemeinen sind nach wenigen Iterationsschritten die zunächst korrekten Werte für den Ladezustand SOC und die Kapazität Qᵥ des Akkumulators 1 gefunden. Da sich der Ladezustand des Akkumulators im Betrieb fortwährend ändert und die Kapazität Qᵥ Schwankungen unterworfen ist, müssen die Werte entsprechend mit der Zeit angepasst werden. Zwischen zwei beliebige aufeinanderfolgende Zeitpunkte tᵢ und tᵢ₊₁ (i ist eine beliebige natürliche Zahl) erfolgt eine Entladung der Batterie. Die der Batterie entnommene Ladungsmenge ΔQ wird durch einen Amperestundenzähler gemessen. Der Zeitpunkt tᵢ₊₁ kann dabei relativ frei gewählt werden. Zum einen könnten die Zeitpunkte derart bestimmt werden, dass zwischen zwei aufeinander folgenden Zeitpunkten eine feste Zeitspanne liegt. Zum anderen könnten die Zeitpunkte durch entsprechende Ereignisse getriggert werden. So könnte beispielsweise bei einem Sprung der Stromstärke in der Anschlussleitung 2 ein Zeitpunkt tᵢ₊₁ gesetzt werden. Zu diesem Zeitpunkt tᵢ₊₁ wird dann die an der Batterie 1 anliegende Spannung U_{gemessen}, der Strom I_{gemessen} in den Anschlussleitungen 2 und die Temperatur T erfasst. Aus diesen Werten wird ein neuer Ladezustand SOC gebildet und die Differenz zwischen dem Ladezustand zum Zeitpunkt tᵢ und dem Ladezustand zum Zeitpunkt tᵢ₊₁ gebildet. Ebenso wird die erwartete Ausgangsspannung U_{erwartet} des Akkumulators 1 durch das mathematische Modell berechnet. In dem darauf folgenden Vergleich wird bestimmt, ob die erwartete Spannung U_{erwartet} mit der gemessenen Spannung U_{gemassen} bzw. ob die bestimmte Differenz des Ladezustands ΔSOC mit der gemessenen dem Akkumulator 1 entnommene Ladungsmenge ΔQ im Wesentlichen übereinstimmt. Ist dies der Fall, wird der Ladezustand SOC(tᵢ₊₁) entsprechend angepasst und bis zum nächsten Auslösen der Anpassung der Parameter gewartet. Weichen die Werte jedoch um einen Betrag größer als eine vorgebbare Schwelle ε voneinander ab, so muss erneut der Ladezustand SOC und/oder die Kapazität Qᵥ des Akkumulators 1 angepasst werden. Am sinnvollsten erfolgt hierbei eine Korrektur der Kapazität Qᵥ. Mit diesem neuen Kapazitätswert wird dann erneut die erwartete Spannung U_{erwartet} berechnet und der Vergleich zwischen den beiden Spannungen U_{erwartet} und U_{gemessen} durchgeführt. Diese Iteration wird solange durchgeführt, bis die beiden Spannungswerte durch nicht mehr als eine vorgebbare Schwelle ε unterscheiden.

Abschließend sei ganz besonders hervorgehoben, dass das zuvor rein willkürlich gewählte Ausführungsbeispiel lediglich zur Erörterung der erfindungsgemäßen Lehre dient, diese jedoch nicht auf das Ausführungsbeispiel einschränkt.

## Patentansprüche

1. Verfahren zum Ermitteln des Betriebszustands eines Energiespeichers für elektrische Energie, wobei der Energiespeicher eine Batterie oder einen Akkumulator umfasst, wobei die Klemmenspannung des Energiespeichers, der in den Anschlussleitungen des Energiespeichers fließende Strom und die Temperatur des Energiespeichers oder die Temperatur in der unmittelbaren Umgebung des Energiespeichers erfasst werden, und wobei der Betriebszustand im Wesentlichen durch einzelne Kenngrößen definiert ist,
**dadurch gekennzeichnet, dass** die im Wesentlichen unbekannten Kenngrößen des Energiespeichers geschätzt werden, wobei die Kenngrößen den Ladezustand und die Kapazität umfassen, dass die dem Energiespeicher entnommene Ladungsmenge gemessen wird, dass der Ladezustand mehrfach bestimmt wird, wobei die Bestimmungen in zeitlichem Abstand zueinander erfolgen, und dass die Differenz der Werte des Ladezustands mit der gemessenen dem Energiespeicher entnommenen Ladungsmenge verglichen wird,
dass für die geschätzten Kenngrößen zunächst Startwerte gewählt werden, dass basierend auf den Startwerten und den erfassten Messgrößen mittels eines mathematischen Modells eine erwartete Messgröße bestimmt und mit der erfassten Messgröße verglichen wird,
dass bei einer Abweichung zwischen der Änderung des bestimmten Ladezustands und der tatsächlich entnommenen Ladung der gespeicherte Wert der Kapazität und/oder des Ladezustands über ein vorgebbares Ausmaß hinaus eine oder mehrere der geschätzten Kenngrößen des Akkumulators korrigiert werden und dass bei Abweichen der erwarteten Messgröße von der erfassten Messgröße einer oder mehrere der Startwerte angepasst werden.

2. Verfahren nach Anspruch 1, **dadurch gekennzeichnet, dass** der Energiespeicher eine Nass-Batterie oder ein Nass-Akkumulator ist.

3. Verfahren nach Anspruch 1 oder 2, **dadurch gekennzeichnet, dass** das Bestimmen der erwarteten Messgröße, der Vergleich der erwarteten Messgröße mit der gemessenen Messgröße und das Anpassen der Startwerte bzw. der geschätzten Kenngrößen iteriert wird.

4. Verfahren nach Anspruch 3, **dadurch gekennzeichnet, dass** eine Iteration mit den geschätzten Kenngrößen des vorhergehenden Iterationsschritts durchgeführt wird.

5. Verfahren nach Anspruch 3 oder 4, **dadurch gekennzeichnet, dass** die Iterationen so lange durchgeführt werden, bis sich die Abweichungen zwischen der erwarteten Messgröße und der erfassten Messgröße in einem vorgegebenen Bereich befindet.

6. Verfahren nach einem der Ansprüche 1 bis 5, **dadurch gekennzeichnet, dass** die erfassten Messgrößen nach einer festlegbaren Anzahl von Berechnungsschritten, nach Ablauf einer festlegbaren Zeitspanne und/oder durch andere Kriterien bestimmt aktualisiert werden.

7. Verfahren nach einem der Ansprüche 1 bis 6, **dadurch gekennzeichnet, dass** die dem Energiespeicher entnommene Ladungsmenge durch einen Amperestundenzähler gemessen wird.

8. Verfahren nach einem der Ansprüche 1 bis 7, **dadurch gekennzeichnet, dass** als Startwert typischerweise zu erwartende Werte verwendet werden.

9. Verfahren nach einem der Ansprüche 1 bis 8, **dadurch gekennzeichnet, dass** Startwerte berechnet oder aus einer Tabelle ausgelesen werden.

10. Verfahren nach einem der Ansprüche 1 bis 9, **dadurch gekennzeichnet, dass** Startwerte aus dem Verhalten des Energiespeichers auf ein Ladepuls und/oder Entladevorgang bestimmt wird.

11. Verfahren nach einem der Ansprüche 1 bis 10, **dadurch gekennzeichnet, dass** das mathematische Modell ein Entlademodell, ein Lademodell oder eine Kombination aus beiden umfasst.

12. Verfahren nach einem der Ansprüche 1 bis 11, **dadurch gekennzeichnet, dass** durch das mathematische Modell die erwartete Klemmenspannung des Akkumulators ausgegeben wird.

## Claims

1. Method for establishing the operating state of an energy store for electrical energy, wherein the energy store comprises a battery or an accumulator, wherein the terminal voltage of the energy store, the current flowing in the connection lines of the energy store and the temperature of the energy store or the temperature in the direct vicinity of the energy store are detected, and wherein the operating state is substantially defined by individual parameters, **characterised in that** the substantially unknown parameters of the energy store are estimated, the parameters comprising the charge state and the capacitance, **in that** the charge quantity removed from the energy store is measured, **in that** the charge state is determined multiple times, the determination operations being carried out with temporal spacing from each other, and **in that** the difference of the values of the charge state is compared with the measured charge quantity removed from the energy store,
**in that**, for the estimated parameters, start values are initially selected, **in that**, based on the start values and the measurement variables detected, an anticipated measurement variable is determined by means of a mathematical model and compared with the detected measurement variable,
**in that**, in the event of a deviation between the change of the determined charge state and the charge actually removed, the stored value of the capacitance and/or the charge state beyond a predeterminable extent, one or more of the estimated parameters of the accumulator is/are corrected and **in that**,
in the event of deviation of the anticipated measurement variable from the detected measurement variable, one or more of the start values is/are adapted.

2. Method according to claim 1, **characterised in that** the energy store is a wet-cell battery or a wet-cell accumulator.

3. Method according to claim 1 or claim 2, **characterised in that** the determination of the anticipated measurement variable, the comparison of the anticipated measurement variable with the measured measurement variable and the adaptation of the start values or the estimated parameters is iterated.

4. Method according to claim 3, **characterised in that** an iteration with the estimated parameters of the previous iteration step is carried out.

5. Method according to claim 3 or claim 4, **characterised in that** the iterations are carried out until the deviation between the measurement variable anticipated and the measurement variable detected is in a predetermined range.

6. Method according to any one of claims 1 to 5, **characterised in that** the detected measurement variables are updated after a determinable number of calculation steps, after a determinable period of time has elapsed and/or in a manner determined by other criteria.

7. Method according to any one of claims 1 to 6, **characterised in that** the charge quantity removed from the energy store is measured by means of an ampere-hour meter.

8. Method according to any one of claims 1 to 7, **characterised in that** values which are typically to be anticipated are used as a start value.

9. Method according to any one of claims 1 to 8, **characterised in that** start values are calculated or read from a table.

10. Method according to any one of claims 1 to 9, **characterised in that** start values are determined from the behaviour of the energy store with respect to a charging pulse and/or discharging operation.

11. Method according to any one of claims 1 to 10, **characterised in that** the mathematical model comprises a discharging model, a charging model or a combination of both.

12. Method according to any one of claims 1 to 11, **characterised in that**, by means of the mathematical model, the anticipated terminal voltage of the accumulator is output.

## Revendications

1. Procédé permettant de déterminer l'état de fonctionnement d'un dispositif de stockage d'énergie électrique, ledit dispositif de stockage d'énergie comportant une batterie ou un accumulateur, dans lequel procédé sont enregistrés la tension aux bornes du dispositif de stockage d'énergie, le courant circulant dans les lignes de raccordement du dispositif de stockage d'énergie et la température du dispositif de stockage d'énergie ou la température de l'environnement immédiat du dispositif de stockage d'énergie, et l'état de fonctionnement étant défini pour l'essentiel par des caractéristiques spécifiques,
**caractérisé en ce que** les caractéristiques spécifiques sensiblement inconnues du dispositif de stockage d'énergie sont évaluées, lesdites caractéristiques spécifiques contenant l'état de charge et la capacité, **en ce que** la quantité de charge prélevée dans le dispositif de stockage d'énergie est mesurée, **en ce que** l'état de charge est déterminé à plusieurs reprises, les déterminations étant effectuées à distance dans le temps, et **en ce que** la différence entre les valeurs de l'état de charge et les valeurs mesurées étant comparées à la quantité de charge prélevée dans le dispositif de stockage d'énergie,
**en ce que**, tout d'abord, des valeurs de départ sont choisies pour les caractéristiques spécifiques évaluées, **en ce que**, sur la base des valeurs de départ et des grandeurs de mesure enregistrées, une grandeur de mesure escomptée est déterminée au moyen d'un modèle mathématique et est comparée à la grandeur de mesure enregistrée,
**en ce que**, en présence d'une divergence entre la variation de l'état de charge déterminé et la charge réellement prélevée, à savoir la valeur mémorisée de la capacité et/ou de l'état de charge, supérieure à une valeur prédéfinissable, une ou plusieurs des caractéristiques spécifiques évaluées de l'accumulateur sont corrigées et **en ce que**, en présence d'une divergence entre les grandeurs de mesure escomptées et les grandeurs de mesure enregistrées, une ou plusieurs des valeurs de départ sont ajustées.

2. Procédé selon la revendication 1, **caractérisé en ce que** le dispositif de stockage d'énergie est une batterie liquide ou un accumulateur liquide.

3. Procédé selon la revendication 1 ou 2, **caractérisé en ce que** la détermination des grandeurs de mesure escomptées, la comparaison des grandeurs de mesure escomptées avec les grandeurs de mesure mesurées et l'ajustement des valeurs de départ ou des caractéristiques spécifiques évaluées sont itérés.

4. Procédé selon la revendication 3, **caractérisé en ce qu'**une itération avec les caractéristiques spécifiques évaluées de l'étape d'itération précédente est effectuée.

5. Procédé selon la revendication 3 ou 4, **caractérisé en ce que** les itérations sont effectuées jusqu'à ce que les divergences entre les grandeurs de mesure escomptées et les grandeurs de mesure enregistrées se situent dans une plage prédéfinie.

6. Procédé selon l'une quelconque des revendications 1 à 5, **caractérisé en ce que** les grandeurs de mesure enregistrées sont actualisées après un nombre définissable d'étapes de calcul, à l'expiration d'un intervalle de temps définissable et/ou de manière déterminée par d'autres critères.

7. Procédé selon l'une quelconque des revendications 1 à 6, **caractérisé en ce que** la quantité de charge prélevée dans le dispositif de stockage d'énergie est mesurée par un compteur d'ampères-heure.

8. Procédé selon l'une quelconque des revendications 1 à 7, **caractérisé en ce que** pour les valeurs de départ on utilise de manière typique des valeurs à escompter.

9. Procédé selon l'une quelconque des revendications 1 à 8, **caractérisé en ce que** les valeurs de départ sont calculées ou sont issues d'un tableau.

10. Procédé selon l'une quelconque des revendications 1 à 9, **caractérisé en ce que** les valeurs de départ sont déterminées à partir du rapport du dispositif de stockage d'énergie sur une impulsion de charge et/ou le processus de décharge.

11. Procédé selon l'une quelconque des revendications 1 à 10, **caractérisé en ce que** le modèle mathématique est un modèle de décharge, un modèle de charge ou une combinaison des deux.

12. Procédé selon l'une quelconque des revendications 1 à 11, **caractérisé en ce que** la tension escomptée aux bornes de l'accumulateur est donnée par le modèle mathématique.
